## Europäisches Patentamt
## European Patent Office
## Office européen des brevets

(19)

(11) Numéro de publication : **0 070 760 B1**

(12)
# FASCICULE DE BREVET EUROPÉEN

(45) Date de publication du fascicule du brevet :
**15.04.87**

(21) Numéro de dépôt : **82401270.2**

(22) Date de dépôt : **06.07.82**

(51) Int. Cl.⁴ : **C 30 B 15/24**, C 30 B 13/30, C 30 B 13/14, C 30 B 15/10, C 30 B 11/00

(54) **Procédé de traitement d'une masse liquide sans contact avec les parois d'un dispositif et application de ce procédé à la mise en forme de matériaux en microgravité.**

(30) Priorité : **17.07.81 FR 8113966**

(43) Date de publication de la demande :
**26.01.83 Bulletin 83/04**

(45) Mention de la délivrance du brevet :
**15.04.87 Bulletin 87/16**

(84) Etats contractants désignés :
**DE NL**

(56) Documents cités :
**DE-A- 2 546 246**
**FR-A- 2 344 332**
**FR-A- 2 344 455**
**US-A- 2 927 008**
**Ullmanns Encyklopädie der Technischen Chemie (1981), volume 20, page 700**

(73) Titulaire : **COMMISSARIAT A L'ENERGIE ATOMIQUE Etablissement de Caractère Scientifique Technique et Industriel**
**B.P. 510**
**F-75752 Paris Cedex 15 (FR)**

(72) Inventeur : **Potard, Claude**
**9, Boulevard Jomardière**
**F-38120 Saint Egreve (FR)**

(74) Mandataire : **Mongrédien, André et al**
**c/o BREVATOME 25, rue de Ponthieu**
**F-75008 Paris (FR)**

## Description

La présente invention a pour objet un procédé de traitement d'une masse liquide permettant la sustentation, le positionnement et le moulage de cette dernière sans contact avec les parois d'un récipient, et permettant en particulier la mise en forme de matériaux par solidification.

Les procédés de mise en forme par moulage posent des problèmes importants lorsque les liquides sont corrosifs, comme c'est le cas notamment des alliages métalliques à haute température. Les principaux problèmes posés sont ceux des compatibilités physique et physicochimique entre le matériau constitutif du conteneur et le liquide : il risque d'y avoir des réactions entre les deux matériaux, ce qui nuit à la pureté du produit obtenu, et l'on peut assister à des variations dimensionnelles incompatibles lors de la solidification et suivant les valeurs relatives des coefficients de dilatation thermique.

Ces diverses raisons ont amené l'emploi de nouvelles techniques tendant à la suppression des conteneurs par action de forces de sustentation électromagnétiques, électrostatiques, acoustiques, et même optiques. Cependant ces méthodes sont délicates à utiliser et ne peuvent s'appliquer qu'à de faibles masses en gravité terrestre ; de plus, elles ne permettent pas la mise en forme de masses liquides.

Le document DE-A-2 546 246 décrit un procédé de tirage de monocristaux dans lequel on utilise un disque flottant à la surface du matériau à cristalliser. Ce disque comporte une ouverture par où s'effectue le tirage et les parois de cette dernière peuvent être poreuses pour permettre le passage d'un gaz neutre. On protège ainsi l'interface liquide-solide, mais la masse liquide est en contact avec le disque et avec les parois du récipient.

Les documents FR-A-2 344 455 et FR-A-2 344 332 décrivent des récipients dont les parois comportent des gorges séparées par des arêtes afin de diminuer la surface de contact entre le liquide et les parois. Si le liquide ne touche pas le fond des gorges, il est cependant en contact avec le sommet des arêtes.

La présente invention a pour but de remédier à ces inconvénients en proposant un procédé de sustentation, de positionnement ou de moulage d'une masse liquide contenue dans un dispositif évitant tout contact avec les parois de celui-ci.

Selon la principale caractéristique de ce procédé, chaque élément du dispositif avec lequel la masse liquide peut venir en contact est constitué par une paroi poreuse, on fait passer à travers cette paroi poreuse un gaz chimiquement inerte vis-à-vis de la masse liquide et du matériau constitutif de la paroi poreuse et on contrôle l'écoulement du gaz à travers la paroi poreuse afin de créer un film gazeux entre celle-ci et la masse liquide, assurant ainsi la sustentation, le positionnement ou le moulage de cette masse liquide sans contact avec les éléments du dispositif.

La paroi poreuse peut être réalisée en un matériau fritté ou être percée de fins canaux.

Ainsi, le fait qu'on supprime tout contact mécanique entre le liquide et son conteneur évite d'éventuelles interactions entre le liquide et le matériau constitutif des parois et l'on peut maintenir des masses importantes de liquide dans un récipient. Il est bien entendu que le gaz utilisé pour la manipulation doit être chimiquement inerte vis-à-vis du liquide : un gaz neutre comme l'hélium peut convenir dans de nombreux cas d'applications.

Avantageusement, le film de gaz est créé par l'écoulement forcé de celui-ci à travers les parois du conteneur, de l'extérieur vers la surface du liquide. Une pression dynamique uniforme normale en tout point de la surface s'établit ainsi et équilibre les forces de pression exercées par le liquide. La stabilité du film de gaz, qui est une condition essentielle au maintien de l'isolement entre le liquide et la paroi, est obtenue par le contrôle des écoulements du flux gazeux afin d'éviter les oscillations des surfaces liquides.

L'invention apparaîtra plus clairement à la lecture de la description qui va suivre, donnée à titre d'exemple purement illustratif et nullement limitatif, en référence aux dessins annexés dans lesquels :

la figure 1 est une vue schématique en coupe montrant une goutte liquide supportée par un film de gaz au-dessus d'une paroi poreuse horizontale,

la figure 2 est une vue semblable à la figure 1, montrant comment on peut déplacer des gouttes liquides maintenues par film de gaz au-dessus d'une paroi poreuse horizontale,

la figure 3 est une vue schématique en coupe montrant une masse liquide contenue dans un récipient par le procédé selon l'invention,

la figure 4 est une vue schématique en coupe illustrant un procédé de fusion de zone verticale, la partie fondue d'une pièce solide étant contenue à l'intérieur d'un manchon sans contact avec les parois de celui-ci,

la figure 5 illustre un procédé de tirage vertical,

les figures 6a et 6b illustrent un procédé de maintien et de mise en forme d'un matériau solide par fusion de zone horizontale dans lequel un manchon se déplace le long de la pièce solide, la zone fondue étant séparée des parois du manchon par un film de gaz,

la figure 6c représente un appareil de fusion de zone horizontale,

la figure 7 est une vue schématique montrant une masse liquide allongée placée en microgravité spatiale et maintenue à l'aide de parois poreuses diffusant un film de gaz,

la figure 8 est une vue schématique en coupe montrant un procédé de coulée continue dans lequel une partie de la masse liquide contenue dans le récipient s'écoule dans un manchon tout en étant séparée des parois de celui-ci par un film de gaz,

la figure 9 est une vue schématique en coupe montrant un procédé de mise en forme d'une pièce solide par solidification verticale, utilisant le procédé selon l'invention, et

la figure 10 illustre un procédé de mise en forme d'une plaque de silicium photovoltaïque par traction verticale utilisant le procédé de sustentation selon l'invention.

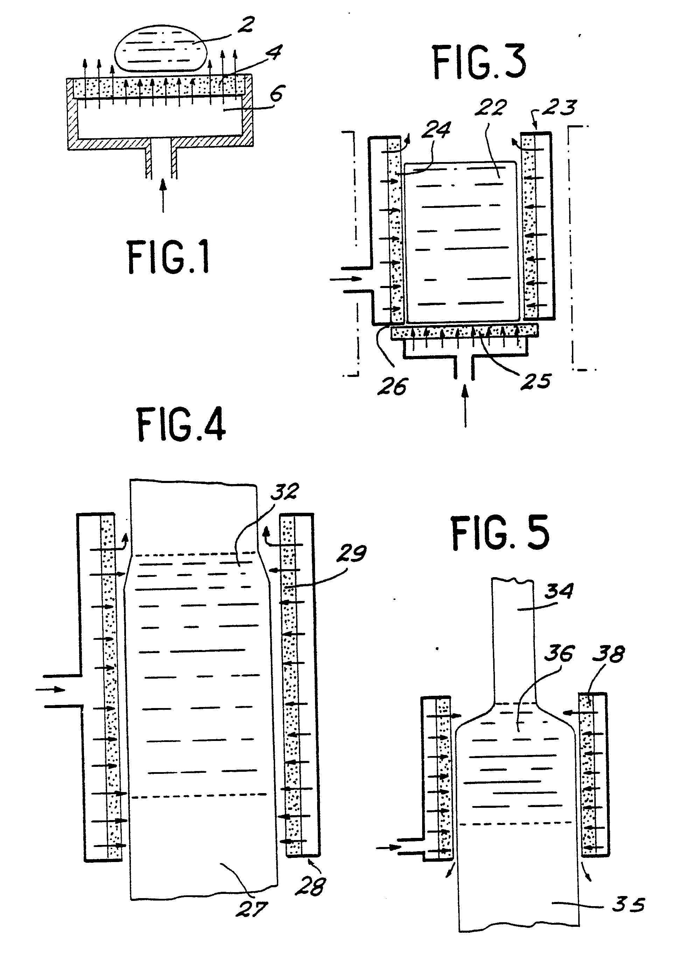

La figure 1 montre comment une goutte de silicium liquide 2 peut être supportée au-dessus d'une paroi 4 à l'aide d'un film de gaz sans aucun contact entre la goutte 2 et la paroi 4. La plaque 4 est poreuse et constitue la paroi diffusante d'une chambre 6 permettant la mise en pression et en température du gaz employé. Suivant les cas, on peut placer directement une goutte liquide en contact avec la paroi et la soulever en forçant une masse de gaz à travers cette paroi, ou utiliser une masse solide que l'on sustente par film de gaz et que l'on fond ensuite. Dans le cas particulier représenté sur la figure 1, un parallélépipède de 10 g environ de silicium solide a été disposé au centre d'une plaque 4 en graphite à 32 % de porosité ouverte, l'épaisseur de la plaque étant voisine de 3 mm. On réalise d'abord la sustentation du bloc de silicium solide en faisant diffuser de l'hélium à travers la paroi 4. L'ensemble étant placé dans un four à résistances n'induisant aucune force électromagnétique sur la masse de silicium, le chauffage est mis en marche et augmenté jusqu'à fusion du silicium. Celui-ci se rassemble sous forme de goutte, essentiellement sous l'action de la tension superficielle élevée du silicium liquide. Afin de maintenir la goutte 2 au même endroit de la surface externe de la plaque 4, on a donné à celle-ci une forme légèrement concave. En effet, le poids de la goutte étant équilibré par la pression du film de gaz, si aucune force de rappel ne la maintient, elle acquiert une grande mobilité sous l'effet de forces minimes non contrôlées. C'est pourquoi l'on prévoit une forme de paroi légèrement concave afin d'éviter un déplacement accidentel de la goutte.

Dans certains cas cependant, il peut être nécessaire de déplacer des gouttes liquides maintenues au-dessus d'une paroi horizontale par film de gaz.

La figure 2 illustre un procédé permettant une telle opération. Sur cette figure, on voit deux gouttes 8 et 10 maintenues au-dessus d'une paroi poreuse 12 par un film de gaz selon le procédé objet de l'invention. Le gaz de sustentation arrive à travers un orifice 14 dans une chambre 16 et diffuse à travers la paroi 12. Afin de déplacer les gouttes 8 et 10, on crée des surpressions ou des dépressions locales : pour cela, on utilise des tiroirs 18 mobiles à l'intérieur de la chambre 16. Les tiroirs mobiles 18 commandés par les tiges 19 comportent chacun une mince plaque poreuse 20, de même nature que la paroi 12, qui augmente localement la perte de charge des gaz, créant ainsi des dépressions sur la paroi dans lesquelles les gouttes 8 et 10 se stabilisent. Le déplacement des tiroirs 18, à l'aide des tiges 19, entraîne le déplacement des zones de dépression et donc celui des gouttes.

Les procédés qui viennent d'être décrits en référence aux figures 1 et 2 ne s'appliquent qu'à des gouttes ou des masses liquides faibles. Dans le cas de masses plus importantes, il est nécessaire d'utiliser des récipients dans lesquels la masse liquide est séparée des parois par un film de gaz.

La figure 3 illustre un procédé de maintien d'une masse liquide 22 à l'intérieur d'un récipient 23 sans qu'aucune partie de la masse liquide ne soit en contact avec les parois ou le fond du récipient. Les parois 24 de celui-ci sont poreuses afin de permettre le passage du gaz utilisé pour la sustentation et le positionnement. Le fond 25 du récipient 23 est également constitué par une paroi poreuse à travers laquelle est amené le gaz utilisé pour la sustentation. Il y a lieu de remarquer que, dans ce cas, les films de gaz situés entre le fond du récipient et la masse liquide d'une part, entre les parois du récipient et la masse liquide d'autre part, ne jouent pas le même rôle. La pression du film de gaz situé entre le fond 25 et le liquide 22 sert uniquement à compenser le poids de celui-ci tandis que le film gazeux situé entre le liquide et les parois 24 du récipient sert à compenser la pression hydrostatique variable de la colonne liquide. De plus, le fond 25 du récipient 23 n'est pas en contact avec les parois 24 : en effet, une ouverture 26 est ménagée à la partie inférieure du récipient pour permettre l'écoulement du gaz diffusé à travers les parois poreuses.

Le procédé selon l'invention trouve des applications nombreuses et variées, notamment pour la mise en forme de matériaux à partir d'une masse liquide. Il rend en particulier de grands services dans la fusion de zone. Les procédés actuels de fusion de zone présentent des inconvénients, notamment lorsque la pièce de départ est en position verticale, à cause de l'instabilité de la zone liquéfiée qui risque de s'effondrer sous l'action de son propre poids lorsque la hauteur de la partie liquide est trop importante. Le procédé selon la présente invention remédie à ces inconvénients en permettant le maintien de matériaux subissant une opération de fusion de zone, même lorsque les dimensions de la zone liquéfiée (hauteur et diamètre) sont importantes. Pour cela, on maintient la zone fondue à l'intérieur d'un manchon à parois poreuses, à l'aide d'un film de gaz, aucun point de la masse fondue n'étant en contact avec les parois du manchon. Bien entendu, la section de ce dernier peut être de forme quelconque permettant l'obtention de profils variés.

La figure 4 illustre un procédé de maintien dans une forme déterminée d'une partie liquide d'une pièce métallique, par exemple une pièce métallique monocristalline 27 placée dans un appareil de fusion de zone verticale. La pièce 27 est placée à l'intérieur d'un manchon chauffant 28 comportant des parois poreuses 29 afin de permettre le passage d'un gaz sous pression. Ce manchon 28 se déplace verticalement. La partie liquéfiée 32 de la pièce 27 est maintenue sans contact direct avec les parois 29 du manchon par le gaz diffusé à travers ces dernières. Au fur et à mesure du déplacement vertical du manchon 28 la zone fondue 32 se déplace simultanément. Bien entendu, le procédé s'applique également au cas où la pièce se déplace à l'intérieur du manchon, celui-ci restant fixe.

La figure 5 illustre un procédé de tirage vertical, dit « procédé de Czochralski ». De manière classique, celui-ci consiste à amener un tube très fin au contact de la surface libre d'un matériau fondu. Le liquide monte par capillarité le long du tube et se solidifie, formant un germe. On montre ensuite le tube très lentement et le liquide qui adhère au germe se solidifie au fur et à mesure du déplacement. La figure 5 illustre un tel procédé dans lequel la masse liquide est maintenue sans contact avec les parois d'un récipient par le procédé selon l'invention. Sur cette figure, on voit la masse liquide 36 du matériau 35 maintenue par un manchon diffusant et chauffant 38. La pièce terminée et tirée est représentée en 34.

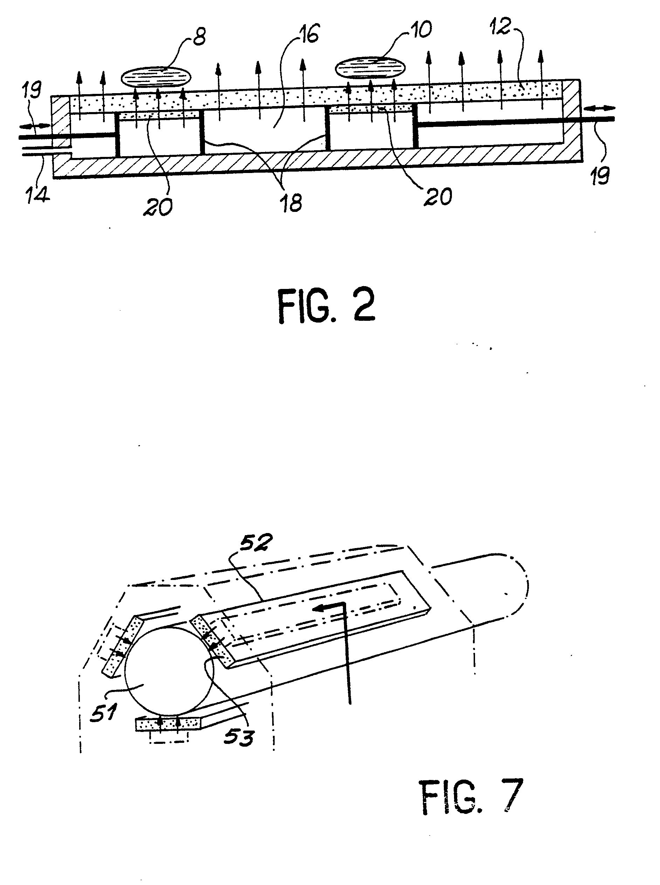

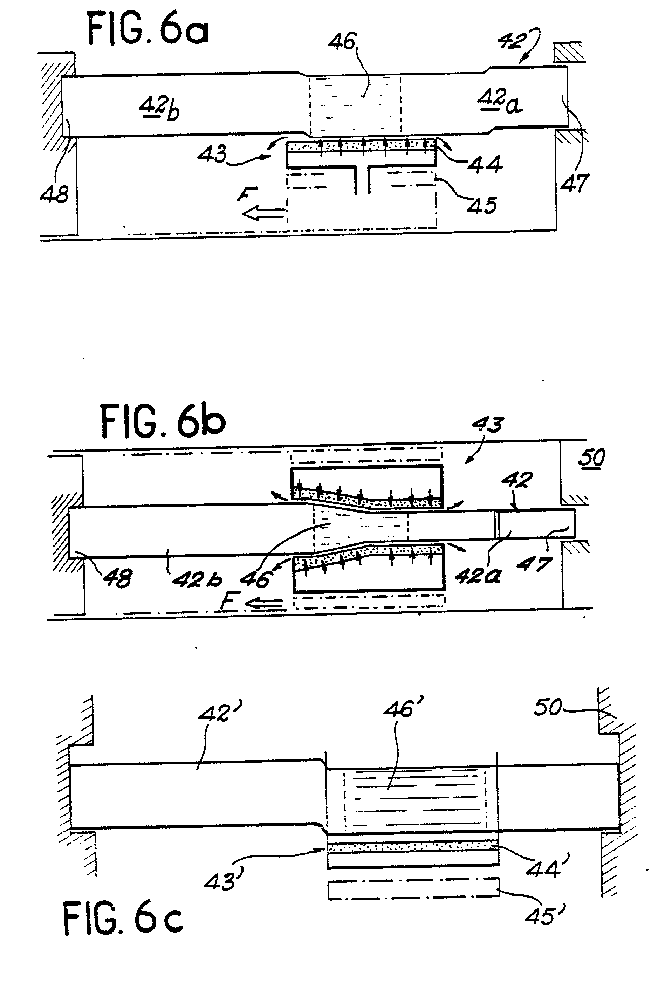

Le cas de la fusion de zone horizontale avec modification de section est illustré sur les figures 6a et 6b où l'on voit une pièce solide 42 maintenue horizontalement par ses deux extrémités et un manchon 43 permettant une réduction de la section entourant la pièce 42 et dont les parois 44 sont poreuses : ce manchon peut se déplacer le long de la pièce 42 dans le sens indiqué par la flèche F. Des moyens de chauffage 45 permettent de liquéfier la partie de la pièce 42 située à l'intérieur de celui-ci, la masse liquide 46 étant maintenue et mise en forme à l'intérieur du manchon grâce au film de gaz sous pression amené à travers les parois effusantes 44. Dans le cas particulier décrit ici, la figure 6a est une vue latérale du dispositif utilisé dans lequel le manchon 43 a la forme d'un berceau et la figure 6b est une vue de dessus de ce même dispositif. On voit qu'il s'agit ici de diminuer la largeur de la pièce 42 : pour cela, on donne au manchon 43 une forme appropriée afin que la partie liquéfiée 46 puisse réaliser le raccordement entre la partie déjà terminée 42a et la partie à rétrécir 42b de la pièce 42. Dans cet exemple, la pièce 42 s'allonge puisqu'on diminue sa largeur sans modifier sa hauteur. Pour cela, seule la première extrémité 48 de la pièce 42 est fixée tandis que l'autre extrémité 47 peut se déplacer progressivement à l'intérieur d'un support 50. La figure 6c représente un appareil pour effectuer une fusion de zone horizontale sans variation de section dans lequel le manchon 43' a une section en U et supporte la zone liquide 46' grâce au gaz diffusé à travers les parois poreuses 44'. Bien entendu, le manchon 43' peut être dissocié en deux parois verticales et un fond horizontal indépendant. Des moyens de chauffage 45' permettent la fusion de la pièce 42'. On voit que, dans tous les cas, il n'y a aucun contact entre la partie liquéfiée de la pièce 42 et les parois du manchon 43.

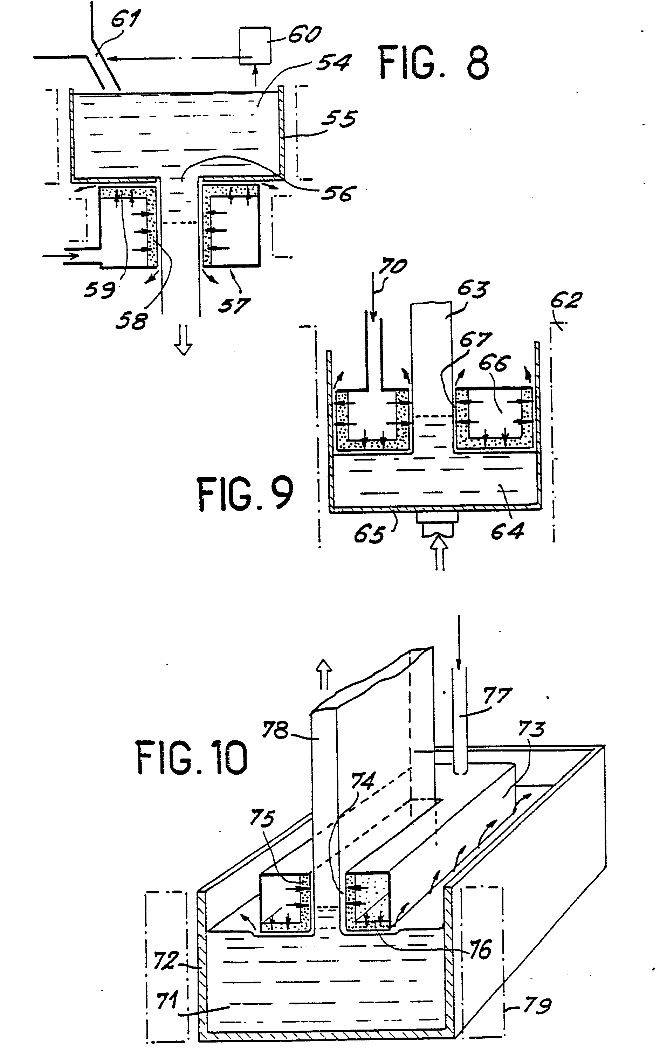

L'invention a encore pour objet une application du procédé objet de l'invention à l'élaboration de matériaux en microgravité spatiale, domaine pour lequel la sustentation des liquides est assurée, mais non leur positionnement ni leur mise en forme. La figure 7 illustre une telle application dans laquelle une masse liquide 51 est maintenue sans contact en microgravité sous une forme allongée. Le positionnement de la masse 51 est assuré par des guide-rails 52 présentant des parois poreuses effusantes 53 à travers lesquelles est introduit un gaz. Etant donné qu'aucun poids ni aucune pression hydrostatique ne s'exercent plus, les flux gazeux nécessaires peuvent être assez faibles.

La figure 8 illustre un procédé de coulée continue utilisant le procédé de sustentation par film de gaz selon l'invention. Sur cette figure, on voit une masse liquide 54 contenue à l'intérieur d'un récipient 55 dont le fond comporte une ouverture 56 pour l'évacuation du liquide et sa solidification par coulée continue. Le liquide s'écoulant à travers l'orifice 56 passe à travers un manchon 57 dont les parois 58 sont poreuses afin de permettre le passage d'un gaz sous pression. Le manchon 57 comporte à sa partie supérieure une autre paroi poreuse horizontale 59 faisant face à la paroi externe du fond du récipient 55 et située à une très faible distance de celui-ci. Le film de gaz ainsi diffusé entre la paroi 59 et le fond du récipient sert à empêcher l'amorce de mouillage par le liquide s'écoulant à travers l'orifice 56 de la face interne du manchon. Un détecteur de niveau 60 relié à une alimentation 61 commande l'arrivée de liquide au fur et à mesure que le niveau de celui-ci dans le récipient 55 baisse. Un réglage convenable de la température du gaz diffusant à travers les parois 58 permet de positionner l'interface solide-liquide à un endroit convenable à l'intérieur du manchon 57.

Bien que, sur le dessin, la masse liquide soit en contact avec les parois du récipient 55, l'invention ne concerne que le cas où celles-ci sont poreuses afin de permettre le passage d'un gaz sous pression pour qu'il n'y ait aucun contact entre le liquide et les parois du dispositif.

Le procédé selon l'invention peut encore s'appliquer à la mise en forme de matériaux par solidification verticale par le haut. Celle-ci consiste à réaliser l'immersion forcée d'une pièce de forme comprenant une ouverture pourvue d'un manchon effusant de façon à provoquer la montée du liquide dans le manchon.

La figure 9 illustre un tel procédé dans lequel une pièce solide 63 est réalisée à partir d'une masse liquide 64 contenue dans un récipient 65. Ce dernier est placé à l'intérieur d'un four 62 afin de maintenir liquide la masse 64. Le maintien en position de la partie de la masse liquide adhérant à la partie solidifiée 63 se fait encore par le procédé selon l'invention. Pour cela, on place au-dessus de la surface libre du liquide 64 un dispositif 66 appelé « pièce de forme ». Celle-ci a des dimensions extérieures légèrement inférieures à celles du récipient 65 et présente en son centre une ouverture définissant un passage 67 pour la réalisation de la partie solidifiée 63. Les parois de la pièce de forme 66 situées en regard de la paroi interne du récipient 65, en regard de la surface libre du liquide 64 et dans le manchon 67 sont poreuses afin de permettre le passage d'un gaz introduit par l'ouverture 70. Le gaz diffusant à travers les parois poreuses de la pièce 66 permet, après immersion partielle de la pièce 66 dans le bain, de maintenir une partie de la masse liquide à l'intérieur du manchon 67. Le liquide mis en forme se solidifie dans le manchon 67. Le gaz diffusant à travers les parois situées en regard de la surface libre du liquide 64 sert à l'isolation et le film de gaz interposé entre les parois externes de la pièce 66 et la paroi interne du récipient 65 empêche le liquide de monter le long de celle-ci. Au fur et à mesure que la pièce solide 63 est formée, le niveau du liquide 64 dans le récipient 65 baisse. Comme la pièce de forme 66 a une position fixe, un dispositif est prévu afin de soulever le récipient au cours de l'élaboration.

Enfin, une dernière application intéressante du procédé selon l'invention est la mise en forme, par traction verticale, de plaques de silicium photovoltaïque. La figure 10 représente un dispositif pour l'application d'un tel procédé. Sur cette figure, on voit une masse de silicium fondu 71 placée à l'intérieur d'un creuset 72 en carbone vitreux lui-même placé sur un support réglable en hauteur (non représenté). Au-dessus de la surface libre du liquide 71 est disposée une pièce de forme 73 présentant en son centre une fente verticale définissant un manchon 74, de 1 mm de large, 10 mm de haut et 50 mm de long dont les parois 75 sont poreuses. L'ensemble est placé à l'intérieur d'un four 79. La paroi 76 de la pièce 73 faisant face à la surface libre du liquide 71 est également poreuse. Le gaz est amené à l'intérieur de la pièce 73 par une canalisation d'entrée 77. Au départ, on amène la paroi inférieure 76 de la pièce de forme 73 au voisinage de la surface libre du liquide 71. Le gaz est alors introduit et la température à l'intérieur de la fente est stabilisée à quelques degrés au-dessous du point de fusion du silicium. Un germe plat de 0,5 mm d'épaisseur est alors introduit dans la fente 74 jusqu'à contacter la surface du liquide. Une interface solide-liquide est alors formée et sa position est ensuite fixée à l'intérieur de la fente par un réglage convenable des moyens de chauffe du four 79. Le tirage peut alors commencer à la vitesse choisie. Là encore, au fur et à mesure que la plaque 78 est formée, le niveau du liquide baisse. La pièce de forme étant fixe par rapport au four 79, les variations de niveau du bain sont compensées par l'élévation continue du creuset 72.

Il est à noter que, si les figures 9 et 10 représentent la masse liquide 64, 71 en contact avec les parois des récipients 65, 72, l'invention ne concerne que le cas où les parois de ces récipients sont poreuses afin de permettre le passage d'un gaz sous pression pour qu'il n'y ait aucun contact entre la masse liquide et le dispositif d'élaboration.

Le procédé selon l'invention présente de nombreux avantages puisqu'il permet la mise en forme de matériaux solides à partir d'une masse liquide sans contact entre celle-ci et les parois du récipient qui la contient, ce qui évite d'éventuelles interactions et permet d'obtenir un produit final de grande pureté. Le procédé s'applique à diverses méthodes de mise en forme, plus spécialement fusion de zone, coulée continue, solidification par traction verticale et élaboration de verres de grande pureté. Il trouve également une application dans le maintien et le positionnement de masses liquides en microgravité. Il permet également de déplacer des masses liquides au-dessus d'une paroi horizontale sans contact avec celle-ci.

Enfin, il est bien entendu que l'invention ne se limite pas aux seuls exemples qui viennent d'être décrits mais qu'on peut en imaginer des variantes, notamment en ce qui concerne le choix du gaz de sustentation et du matériau constituant les parois poreuses pour la diffusion de celui-ci.

**Revendications**

1. Procédé de sustentation, de positionnement ou de moulage d'une masse liquide (2, 22) contenue dans un dispositif, caractérisé en ce que chaque élément du dispositif avec lequel la masse liquide (2, 22) peut venir en contact est constitué par une paroi poreuse (4, 24, 25), en ce qu'on fait passer à travers cette paroi poreuse (4, 24, 25) un gaz chimiquement inerte vis-à-vis de la masse liquide (2, 22) et du matériau constitutif de la paroi poreuse (4, 24, 25) et en ce qu'on contrôle l'écoulement du gaz à travers la paroi poreuse (4, 24, 25) afin de créer un film gazeux entre celle-ci et la masse liquide (2, 22), assurant ainsi la sustentation, le positionnement ou le moulage de cette masse liquide (2, 22) sans contact avec les éléments du dispositif.

2. Procédé selon la revendication 1, caractérisé en ce que ladite paroi (4) est réalisée en un matériau fritté.

3. Procédé selon la revendication 1, caractérisé en ce que ladite paroi (4) est percée de fins canaux.

4. Procédé selon l'une quelconque des revendications 1 à 3, caractérisé en ce que ladite paroi (4) est de forme sensiblement plane et horizontale.

5. Procédé selon la revendication 4 permettant la sustentation et le déplacement d'une masse liquide (8), caractérisé en ce qu'on diminue localement la pression du film gazeux sur la paroi poreuse (12) en plaçant une pièce mobile poreuse (20) du côté de la paroi (12) opposé à celui où se trouve la masse liquide (8) et en ce qu'on déplace la pièce mobile poreuse (20) afin de provoquer le déplacement de la masse liquide (8).

6. Procédé selon l'une quelconque des revendications 1 à 3 permettant le traitement par fusion de zone d'une pièce (27, 42, 42'), caractérisé en ce que la partie liquide (32, 46, 46') de la pièce (27, 42, 42') est contenue dans un manchon poreux chauffant (28, 43, 43'), ledit manchon (28, 43, 43') pouvant se déplacer, relativement, par rapport à la pièce (27, 42, 42').

7. Procédé selon l'une quelconque des revendications 1 à 3, permettant la réalisation d'une pièce solide (63, 78) par solidification verticale à partir d'une masse liquide (64, 71) contenue dans un récipient (65, 72), caractérisé en ce que les parois de ce récipient sont poreuses afin de permettre le passage du gaz utilisé pour la sustentation et en ce qu'on force le liquide à travers un manchon (67, 73) dont les parois sont poreuses afin de permettre le passage du gaz utilisé pour la sustentation, l'interface liquide-solide se trouvant à l'intérieur du manchon (67, 73).

8. Procédé selon l'une quelconque des revendications 1 à 3, permettant la réalisation d'une pièce solide (34) par solidification verticale à partir d'une masse liquide (36), caractérisé en ce que la masse liquide (36) est la partie liquéfiée d'une pièce (35) traitée par fusion de zone, la masse liquide (36) étant contenue dans un manchon poreux chauffant (38) pouvant se déplacer relativement par rapport à la pièce (35).

9. Procédé selon l'une quelconque des revendications 1 à 3, permettant la mise en forme d'une pièce solide par coulée continue à partir d'un liquide (54) contenu dans un récipient (55) dont le fond comporte un orifice d'évacuation (56), caractérisé en ce que les parois et le fond du récipient (55) sont poreux afin de permettre le passage du gaz utilisé pour le moulage et en ce qu'on maintient le liquide qui s'écoule à travers l'orifice (56) à l'intérieur d'un manchon (57) dont les parois sont poreuses afin de permettre le passage du gaz utilisé pour la sustentation.

10. Application du procédé selon l'une quelconque des revendications 1 à 3 à la mise en forme de matériaux en microgravité spatiale.

11. Application du procédé selon l'une quelconque des revendications 1 à 3 à la mise en forme d'un matériau en microgravité spatiale avec maintien d'une masse liquide (51) à l'aide d'un dispositif de mise en œuvre comprenant au moins trois pièces (52) servant de guides, chacune de ces pièces (52) comportant une paroi poreuse (53) située en regard de la masse liquide (51) et permettant le passage d'un gaz sous pression.

## Claims

1. Method of supporting, positioning or moulding a liquid mass (2, 22) contained in a device, characterized in that each element of the device with which the liquid mass (2, 22) can come into contact consists of a porous wall (4, 24, 25), in that a gas which is chemically inert towards the liquid mass (2, 22) and towards the material forming the porous wall (4, 24, 25) is passed through this porous wall (4, 24, 25) and in that the flow of the gas through the porous wall (4, 24, 25) is controlled in order to create a gas film between the latter and the liquid mass (2, 22) thus ensuring the support, the positioning or the moulding of this liquid mass (2, 22) without contact with the elements of the device.

2. Method according to Claim 1, characterized in that the said wall (4) is made of a sintered material.

3. Method according to Claim 1, characterized in that the said wall (4) is pierced with fine channels.

4. Method according to any one of Claims 1 to 3, characterized in that the said wall (4) is substantially planar in shape and horizontal.

5. Method according to Claim 4, permitting the support and the displacement of a liquid mass (8) characterized in that the pressure of the gas film on the porous wall (12) is reduced locally by placing a movable porous component (20) at the opposite side of the wall (12) to that where the liquid mass (8) is situated and in that the movable porous component (20) is displaced in order to produce the displacement of the liquid mass (8).

6. Method according to any one of Claims 1 to 3, permitting an article (27, 42, 42') to be treated by zone melting, characterized in that the liquid part (32, 46, 46') of the article (27, 42, 42') is contained in a porous heating sleeve (28, 43, 43'), the said sleeve (28, 43, 43') being capable of relative displacement in relation to the article (27, 42, 42').

7. Method according to any one of Claims 1 to 5, permitting the production of a solid article (63, 78) by vertical solidification from a liquid mass (64, 71) contained in a receptacle (65, 72), characterized in that the walls of this receptacle are porous in order to permit the gas used for the support to pass through and in that the liquid is forced through a sleeve (67, 73) whose walls are porous in order to permit the gas used for the support to pass through, the liquid/solid interface being inside the sleeve (67, 73).

8. Method according to any one of Claims 1 to 3, permitting the production of a solid article (34) by vertical solidification from a liquid mass (36), characterised in that the liquid mass (36) is the liquefied part of an article (35) treated by zone melting, the liquid mass (36) being contained in a porous heating sleeve (38 capable of relative displacement in relation to the article (35).

9. Method according to any one of Claims 1 to 3, permitting the shaping of a solid article by continuous casting from a liquid (54) contained in a receptacle (55) whose bottom comprises a discharge orifice (56), characterized in that the walls and the bottom of the receptacle (55) are porous in order to permit the gas used for the moulding to pass through and in that the liquid which flows out through the orifice (56) is maintained inside a sleeve (57) whose walls are porous in order to permit the gas used for the support to pass through.

10. Application of the method according to any one of Claims 1 to 3 to the shaping of materials in space microgravity.

11. Application of the method according to any one of Claims 1 to 3 to the shaping of a material in space microgravity, with a liquid mass (51) being maintained with the aid of a holding device comprising at least three components (52) serving as guides, each of these components (52) comprising a porous wall (55) situated facing the liquid mass (51) and permitting a gas under pressure to pass through.


**Patentansprüche**

1. Verfahren zur Abstützung, zur Positionierung oder zur Formung einer flüssigen Masse (2, 22), die in einer Einrichtung enthalten ist, dadurch gekennzeichnet, daß jedes Element der Einrichtung, mit dem die flüssige Masse (2, 22) in Berührung treten kann, von einer porösen Wand (4, 24, 25) gebildet ist, und daß man durch diese poröse Wand (4, 24, 25) ein gegenüber der flüssigen Masse (2, 22) und dem die poröse Wand (4, 24, 25) bildenden Material chemisch inertes Gas hindurchleitet, und daß man die Strömung des Gases durch die poröse Wand (4, 24, 25) so steuert, daß ein Gasfilm zwischen ihr und der flüssigen Masse (2, 22) gebildet wird, der auf diese Weise die Abstützung, die Positionierung oder die Formung dieser flüssigen Masse (2, 22) ohne Berührung mit den Elementen der Einrichtung sicherstellt.

2. Verfahren nach Anspruch 1, dadurch gekennzeichnet, daß die genannte Wand (4) aus einem Sintermaterial besteht.

3. Verfahren nach Anspruch 1, dadurch gekennzeichnet, daß die genannte Wand (4) von feinen Kanälen durchdrungen ist.

4. Verfahren nach einem der Ansprüche 1 bis 3, dadurch gekennzeichnet, daß die genannte Wand (4) im wesentlichen ebene Gestalt hat und horizontal ist.

5. Verfahren nach Anspruch 4, das die Abstützung und Verschiebung einer flüssigen Masse (8) erlaubt, dadurch gekennzeichnet, daß man örtlich den Druck des Gasfilms auf der porösen Wand (12) vermindert, indem man ein poröses bewegliches Stück (20) auf der Seite der Wand (12) anordnet, die jener entgegengesetzt ist, an der sich die flüssige Masse (8) befindet, und daß man das bewegliche poröse Stück (20) verschiebt, um die Verschiebung der flüssigen Masse (8) hervorzurufen.

6. Verfahren nach einem der Ansprüche 1 bis 3, das die Behandlung eines Werkstücks (27, 42, 42') durch Zonenschmelzen gestattet, dadurch gekennzeichnet, daß der flüssige Teil (32, 46, 46') des Werkstücks (27, 42, 42') in einer porösen Heizmanschette (28, 43, 43') enthalten ist, wobei sich die Manschette (28, 43, 43') relativ gegenüber dem Werkstück (27, 42, 42') verschieben kann.

7. Verfahren nach einem der Ansprüche 1 bis 3, das die Herstellung eines festen Werkstücks (63, 78) durch vertikale Verfestigung einer in einem Behälter (65, 72) enthaltenen flüssigen Masse (64, 71) gestattet, dadurch gekennzeichnet, daß die Wände des Behälters porös sind, um den Durchgang von Gas zu gestatten, das für die Abstützung verwendet wird, und daß man die Flüssigkeit durch eine Manschette (67, 73) drückt, deren Wände porös sind, um den Durchgang des für die Abstützung verwendeten Gases zu gestatten, wobei sich die Flüssig/Fest-Grenzfläche in dem von der Manschette (67, 73) umschlossenen Bereich befindet.

8. Verfahren nach einem der Ansprüche 1 bis 3, das die Herstellung eines festen Werkstücks (34) durch vertikale Verfestigung einer flüssigen Masse (36) gestattet, dadurch gekennzeichnet, daß die flüssige Masse (36) das verflüssigte Teil eines durch Zonenschmelzen behandelten Werkstücks (35) ist, wobei die flüssige Masse (36) sich in einer porösen Heizmanschette (38) befindet, die relativ gegenüber dem Werkstück (35) verschiebbar ist.

9. Verfahren nach einem der Ansprüche 1 bis 3, das die Formgebung eines festen Werkstücks durch fortwährendes Gießen einer Flüssigkeit (54) gestattet, die in einem Behälter (55) enthalten ist, dessen Boden eine Abzugsöffnung (56) aufweist, dadurch gekennzeichnet, daß die Wände und der Boden des Behälters (55) porös sind, um den Durchgang von für das beim Gießen verwendete Gas zu gestatten, und daß man die Flüssigkeit, die durch die Öffnung (56) ausfließt, in einer Manschette (57) hält, deren Wände porös sind, um den Durchgang des für die Abstützung verwendeten Gases zu gestatten.

10. Anwendung des Verfahrens nach einem der Ansprüche 1 bis 3 zur Formgebung von Materialien bei Weltraum-Mikrogravitation.

11. Anwendung des Verfahrens nach einem der Ansprüche 1 bis 3 zur Formgebung eines Materials bei Weltraum-Mikrogravitation, wobei eine flüssige Masse (51) mit Hilfe einer Ausführungseinrichtung gehalten wird, die wenigstens drei Teile (52) aufweist, die als Führungen dienen, wobei jedes dieser Teile (52) eine poröse Wand (53) aufweist, die der flüssigen Masse (51) gegenübersteht und den Durchlaß eines Gases unter Druck gestattet.

FIG.1

FIG.3

FIG.4

FIG. 5

## FIG. 2

## FIG. 7

## FIG. 6a

46

42

**42b**

**42a**

43

44

45

48

47

F

## FIG. 6b

43

50

42

48

42b

46

42a

47

F

## FIG. 6c

42'

46'

50

43'

44'

45'

FIG. 8

FIG. 9

FIG. 10